Europäisches Patentamt

European Patent Office

Office européen des brevets

(11) Publication number: **0 267 040**
**A2**

## EUROPEAN PATENT APPLICATION

(21) Application number: **87309817.2**

(22) Date of filing: **05.11.87**

(51) Int. Cl.4: **H 03 M 1/24**

(30) Priority: **07.11.86 JP 263993/86**
**07.11.86 JP 263995/86**

(43) Date of publication of application:
**11.05.88 Bulletin 88/19**

(84) Designated Contracting States: **DE FR GB**

(71) Applicant: **KABUSHIKI KAISHA EMPIRE AIRPORT SERVICE**
**34-6, Shiba 5-chome, Minato-ku**
**Tokyo (JP)**

(72) Inventor: **Miyamoto, Takehiko**
**6-19, Shimoshakuji 1-chome**
**Nerima-ku Tokyo (JP)**

(74) Representative: **Kennedy, Victor Kenneth et al**
**G.F. REDFERN & CO. Marlborough Lodge 14 Farncombe Road**
**Worthing West Sussex BN11 2BT (GB)**

(54) **Absolute measurement encoders.**

(57) An absolute measurement encoder (10) is coupled to a drive shaft (30,230), which is rotatably driven by a motor (65,265) for detecting the amount of rotation of the drive shaft. The encoder includes a rotary disc (20,220) storing positional information and rotated in accordance with rotation of the drive shaft; a magnetic head (10,210) for reading (in the form of a serial signal sequence or sequences) the positional information stored on the rotary disc; a counter (103) for counting and holding information read by the magnetic head and feeding out the information in the form of parallel information; and a battery (15) for supplying operating power to the counter and magnetic head, if required.

FIG. 1

**Description**

ABSOLUTE MEASUREMENT ENCODERS:

The present invention relates to absolute measurement encoders for use directly mounted on a drive shaft of a servomotor or the like.

Along with the advances that have recently been made in the field of robotics and automatic machinery, encoders which serve as devices for detecting rotational changes of position, and of linear position along a straight line, have come into wide usage for the purpose of controlling robots and/or other such machines. A variety of such encoders are now available.

Owing to their structural simplicity and low cost, it is most common to use incremental type encoders to position servomechanisms, particularly the rotating portions thereof.

However, for reasons which will now be set forth, there has recently been an increase in demand for absolute measurement type encoders. Specifically, when controlling the position of a robot, by way of example, the required processing is to sense a home position first, and then use this position as a reference when putting the robot through its motions. (With an incremental type encoder, this operation is required whenever the power supply is turned on). If this initial process for sensing the home position includes an error, then all subsequent motions of the robot will incorporate that error. Accordingly, this initial processing operation must be performed with great care, and can become troublesome. If an absolute measurement type encoder is used, these settings need be made only once, after which operation can start immediately, regardless of how many times the power supply is turned on and off, providing the details of the current work process do not change. Thus, with an absolute measurement type encoder, troublesome initial processing is not required.

There is an increasing demand not only for absolute measurement encoders of a conventional type which detect absolute position for any single revolution, but also for absolute measurement encoders capable of detecting absolute position for a large number of revolutions.

With the progress that has recently been made in science and technology, devices which utilize automatic control are becoming increasingly smaller in size, and it is desirable that the encoders used in these devices also be reduced in size.

A rotary encoder is used by being directly mounted on a servomotor shaft. In the case of a so-called "built-in" type encoder, conventionally the encoder used is preferably of the type which will not cause the motor shaft to develop play in the axial direction. In such an encoder, a rotary disc is directly attached to the shaft or the rotary encoder itself, which is equipped with a plurality of bearings, whereby the rotary disk is securely mounted without allowing motion of the rotary disc other than rotational motion, and in such a manner that other structural portions of the rotary encoder are not adversely affected. The entire arrangement is commonly mounted on the motor shaft directly, or through the use of couplings or the like.

However, a motor shaft generally has some play in the axial direction, and disc motion on the encoder side is only limited by bearings arranged in two-point support structure, even in a conventional built-in type encoder, as will be described hereinafter.

Such conventional arrangements have the following problems:

(1) The structure is complicated and therefore costs are high;

(2) If a universal coupling is not used, the motor shaft and the rotary shaft of the encoder may both be damaged unless the axes of the motor shaft and encoder shaft are in adequate precise alignment; and

(3) If a universal coupling is used, the cost is raised, and any play in the coupling has an adverse effect, thereby diminishing accuracy and reliability. Another unavoidable problem is the extra mounting space required to accommodate the increase in length due to the coupling

A first object of the invention is to provide an inexpensive absolute measurement encoder through which an absolute position signal can be extracted over a number of revolutions.

In accordance with a preferred embodiment, the invention comprises an absolute measurement encoder coupled to a drive shaft rotationally driven by driving means, and having means for detecting the actual amount of rotation of the drive shaft, characterised in that a rotary disc is provided for storing position information and rotated in accordance with rotation of the drive shaft; reading means for reading out the positional information stored on said rotary disc as a serial signal sequence or sequences; and logic-linking means feeding said signal sequence or sequences to counting output means for counting and holding information read by said reading means and feeding out the information in parallel mode.

In the above-described configuration, an inexpensive and structurally simple absolute measurement encoder can be provided, by incorporating the power supply and equipping a mechanism similar to that of an incremental type encoder with an arrangement for storing detected position information at all times, and with an arrangement for reading out the stored position information in parallel mode.

A further object of the present invention is to provide a highly reliable encoder which is simple in construction, and yet easily constructed in minute size, but readily mounted.

According to yet another exemplary embodiment of the present invention, this second object is attained by providing an encoder comprising in a single assembly: a rotary disc storing positional information at a prescribed interval and fixedly secured to a motor drive shaft for rotating together with any rotation of the drive shaft, and with reading means including at least two sets of first and second readers spaced apart from each other, by a distance approximately equal to that of a cycle representing a position information write cycle on the rotary disc, the two sets of readers being spaced apart from each other by a distance which is approximately one-half the interval at which the positional information is written on the rotary disc.

The present invention further provides an encoder fixedly secured to a motor and fixed to a drive shaft of the motor for detecting an amount of rotation of the drive shaft and comprising: a disc drive shaft having a hollow portion in which the drive shaft of the motor is fitted and retained; a rotary disc storing positional information and fixedly secured to the disc drive shaft for rotating in accordance with rotation of the disc drive shaft; reading means for reading the positional information stored on the rotary disc; and supporting means disposed adjacent a fixed side of the motor for supporting the disc drive shaft in such manner that the drive shaft is freely rotatable and fixed against movement in the axial direction.

This latter arrangement makes it possible to provide an encoder which is both inexpensive, simple in construction, and yet small in size.

The invention will now be described with reference to the drawings, in which:

Figure 1 is a perspective schematic view showing the positional relationship between a rotary disc and magnetic head in exemplary embodiments of the invention;

Figure 2 is a detailed cross-sectional view of one exemplary embodiment of the invention;

Figure 3 is a block schematic circuit diagram of a control substrate constructed in accordance with one exemplary embodiment of the invention;

Figure 4 is a cross-sectional view of part of a second exemplary embodiment of the invention;

Figure 5 is an explanatory diagram showing the positional relationship between the sensors of a magnetic head and the positions at which positional information is written in in accordance with the second embodiment;

Figure 6 is a fragmentary block-schematic circuit diagram of an output circuit for use in the second exemplary embodiment;

Figure 7 is an explanatory magnified cross-sectional view for describing assembly tolerances used in the second exemplary embodiment;

Figure 8 is a block-schematic circuit diagram of a portion of a control substrate constructed in accordance with another exemplary embodiment of the invention; and

Figures 9(A) and 9(B) are respective cross-sectional views of alternative conventional encoder constructions.

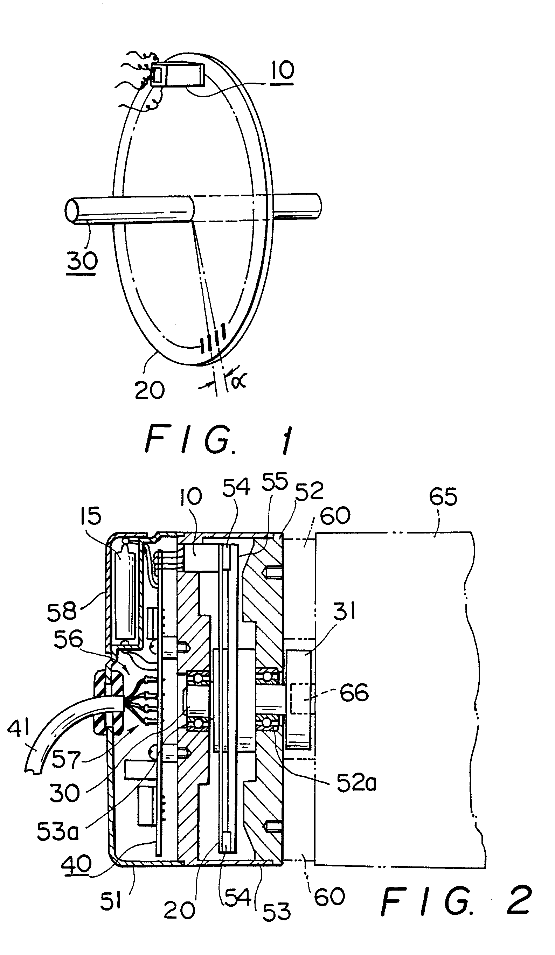

The basic details of the preferred embodiments are shown schematically in Figure 1 to illustrate the positional relationship between a rotary disc (20 and a magnetic head (10). In this embodiment the head (10) is a magnetic head, constituted by an M/R element capable of reading and writing, the disc 20 is a magnetic disc or carries a magnetic material. A drive shaft 30 rotates by an amount corresponding to the amount of movement of an object under control. The magnetic head 10 is disposed at a circumferential surface of the rotary disc 20 having a predetermined radius, or at a position opposing this circumferential surface. The surface of the disc 20 on at least a circumferential portion thereof having a predetermined radius is coated with a magnetic material possessing a strong coercive force.

Figure 2 shows a cross-sectional view of an encoder incorporating the magnetic head 10 and rotary disc 20. The magnetic head 10 has a chargeable secondary battery 15 for constantly supplying power to a control substrate 40 for read control of the magnetic head 10 at all times. The rotary disc 20 is mounted on the drive shaft 30, supporting the rotary disc 20 at its centre of rotation. The control substrate 40, an interface cable 41, and a protective cover 51 protects the control substrate 40. A support base 52 and main support base 53 rotatably support the drive shaft 30. The drive shaft 30 is inserted in bearings 52a and 53a to be rotatably journalled on the support base 52 and main base 53. A ring-shaped, sponge-like resilient body 54 urges the magnetic disc 20 into pressure contact with the magnetic head 10 at a predetermined contact pressure, and a back plate 55 supports the resilient body 54. A protective cover 58 is provided for the secondary battery 15. A motor 65 having a drive shaft 66 is coupled by a joint portion 60.

In the present embodiment, operating power is supplied to the control substrate 40 via the interface cable 41 when external power is being supplied to the motor 65. The control substrate 40 is operated primarily by this external electric power, and this power is also supplied to the battery 15 to automatically recharge it if required. If the operating power for the motor 65 and the like is turned off, the operating power supplied to the encoder through the interface cable 41 is also cut off, after which specific circuits on the control substrate 40 receive power from the battery 15, as described below.

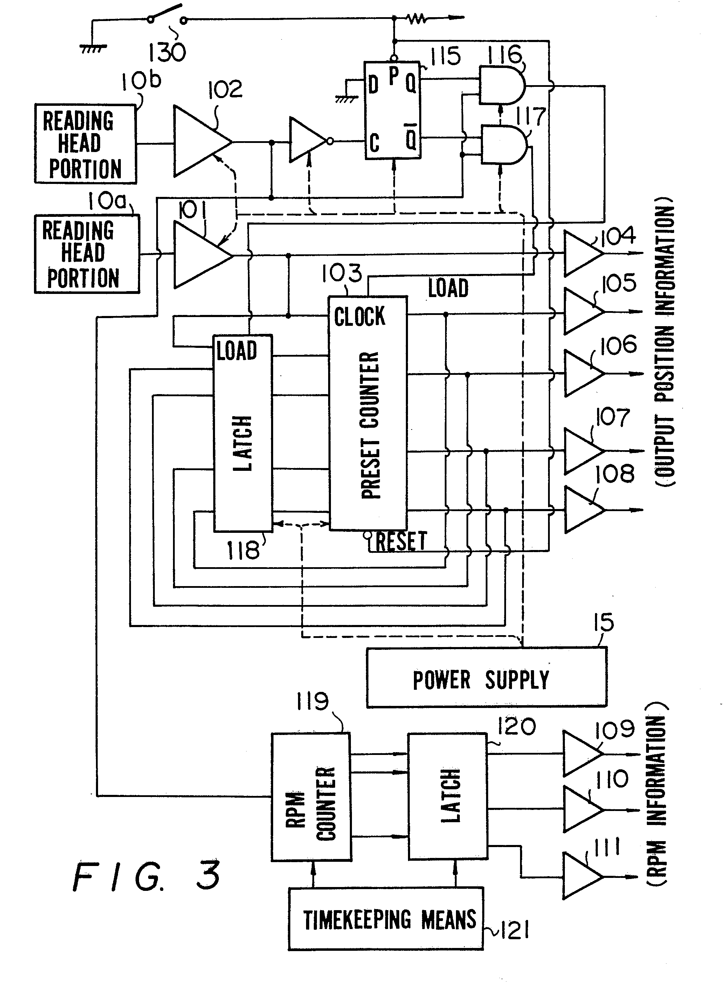

The magnetic head 10 is equipped with reading head portions 10a and 10b (Figure 3) for two corresponding tracks, as will be described later. Pre-recorded magnetic graduations spaced apart by a certain fixed angle $\alpha$ are written beforehand by a well-known method on one magnetic recording track disposed on the magnetic material surface of the rotary disc 20, on a portion thereof opposing a reading head portion 10a of the magnetic head 10, and a reference position signal Z indicating a rotational reference position of the magnetic disc 20 is recorded on another magnetic recording track, disposed on the magnetic material surface of disc 20 opposing the other reading head portion 10b.

Figure 3 shows a block-schematic circuit arrangement for the control substrate 40. The arrangement includes amplifier circuits 101 and 102 for amplifying read signals from the respective reading head portions 10a and 10b. A counter 103 counts position information (an A signal), indicative of the position of rotary disc 20, which is received in serial form from the read head portion 10a after being amplified by the amplifier circuit 101. The recorded count is fed out in parallel mode via buffer amplifiers 104 to 111. The counter 103 can have any capacity, depending upon the resolution of the position information stored on the rotary disc 20, and it will suffice if individual parallel position information having one-to-one correspondence with respect to each item of position information on the magnetic disc 20 is fed out. Specifically, parallel information "0", "1", ... "n-1", "n" is fed out, and each value has one-to-one correspondence with respect to the positions at which the positional information is written on the rotary disc 20.

A D-type flip-flop F/F 115 is set by an input from a reset switch 130, and has its D terminal held at ground level. As a result, the F/F 115 is reset at the clock timing, namely the timing of the negative-going transition of the Z-signal (the clock input) from the read head portion 10b. AND gates 116 and 117 are provided, the AND gate 116 feeding a pulse synchronised to the Z-signal at the arrival of the Z-signal when the F/F 115 is in the set state, and the AND gate 117 feeding out a pulse synchronised to the Z-signal on the arrival of the Z-signal when the F/F 115 is in the reset state. A latch circuit 118 latches the count in counter 103 as reference position information at the first arrival of the Z-signal following an input from the reset switch 130. Thereafter, the latch circuit 118 presets the counter 103 to the previously latched position information whenever the Z-signal arrives. Thus, the output position information can be made "0" at any timing in response to an input from the reset switch 130, and it is possible to correct any error each time one revolution is completed.

With the exception of the buffers 109 to 111 inclusive, the above components constantly receive power from the secondary battery 15. Thus, even if the driving power is cut off, the data in latch circuit 118 and the count recorded by counter 103 will be preserved. Furthermore, even if the rotary disc 20 rotates during this period, the accompanying rotational position information will always be updated so that correct information indicative of the absolute position of rotary disc 20 can always be put out. Accordingly, the encoder can be handled externally just as an absolute encoder, merely by providing an incremental encoder mechanism and control circuitry with a power supply and a circuit for forming absolute positional information indicative of the absolute position of the rotary disc from the positional information thereon, and for storing the absolute positional information at all times.

In the present embodiment, the aforementioned control circuitry includes an rpm counter 119, a latch circuit 120 and time-keeping means 121. The rpm counter 119 counts the number of Z-signals which arrive within a specified period of time (e.g. 1 minute) decided by the time-keeping means 120, and the value of the count which prevails at the elapse of the specified time period is latched by the latch circuit 120, before being fed out via the buffers 109 to 111. Thus, an output indicative of the rpm of rotary disc 20 can be obtained. Furthermore, at the elapse of the specified time period, the rpm counter 119 is reset and counts the number of Z-signals within the fixed period of time.

These circuits can be arranged to receive power at all times from the battery 15, or only when power is being supplied to the driving source.

As mentioned above, the primary battery 15 is placed in a charging state when external power is supplied to the driving source, and discharges when external power is not connected to the driving source. Naturally the battery 15 can be a primary battery instead of a secondary battery, in which case an arrangement can be adopted in which the supply and removal of power from the battery to the above circuits is performed by changing over a switch. It is also permissible to effect control in such a manner that the switch is changed over to supply power to each of the circuits by cutting off power to the driving source, and to halt the supply of power to these circuits when power is being supplied to the driving source.

In accordance with the present embodiment as described above, even though the basic portion of the encoder is of the incremental type, as seen from the outside, the encoder functions as an absolute measurement encoder. In addition, since the encoder operates electronically, the intitial position (the "0" position) can be set at will and an output of rpm can be obtained.

When a secondary battery is used as set forth above, it becomes necessary to provide a space capable of accommodating the battery. Yet, with the progress that has recently been made in science and technology, devices which utilize automatic control are becoming increasingly smaller in size, and less demanding in consumption so, nevertheless, it is required that the encoders, the battery itself, and these devices can all be reduced in size.

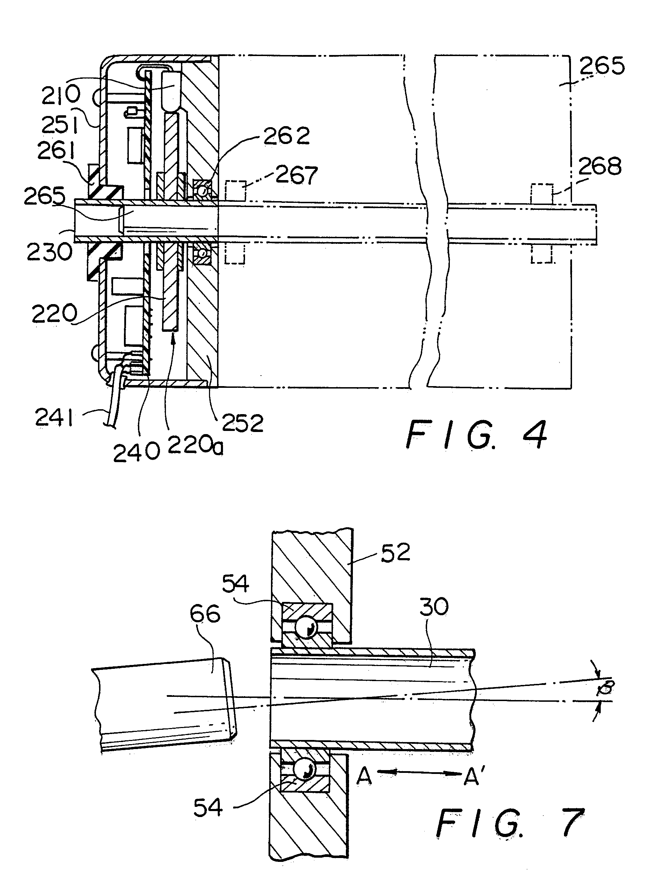

However, a second exemplary embodiment of the invention will now be described with reference to Figures 4 to 8, in which these space requirements are satisfied, and the need for the secondary battery 15 is eliminated.

A cross-sectional view of the second embodiment is shown in Figure 4, and need not be described again.

A magnetic head 210 is an M/R element capable of reading and writing, with two sets of readers, as will be described. A rotary disc 220 is provided which is slightly different from the rotary disc 20 of Figure 1. The rotary disc 220 has an outer peripheral surface 220a coated with a magnetic material possessing a strong coercive force and having pre-recorded positional information written thereon at predetermined intervals. The magnetic head 210 is disposed at a position opposing the outer peripheral surface of the rotary disc 220.

A drive shaft 230 carries the rotary disc 220, and supports the disc at its centre of rotation. The drive shaft 230 has a hollow structure into which a drive shaft 266 of a motor 265 fits snugly, so that the drive shaft 230 will rotate with rotation of the drive shaft 266.

A control substrate 240, an interface cable 241, and a protective cover 251 for protecting the control substrate 240 are provided in this embodiment, the control substrate 240 being attached to the protective cover 251. The drive shaft 230 is passed through the protective cover 251 and is supported by a bushing 261 that is fitted into the protective cover 251 until assembly has been completed. After completion of the assembly, the bushing 261 is removed so that nothing impedes rotation of the drive shaft 230. A support base 252 rotatably supports the drive shaft 230. The magnetic head 210 is fixedly secured to the support base 252, in which support bearings 262 are arranged for securing and supporting the drive shaft 230, whilst allowing the drive shaft to rotate freely.

The support base 252 is secured to the motor 265, and the drive shaft 266 of the motor is fitted into the hollow drive shaft 230, as mentioned above. When this is done, the drive shaft 266 is retained at a prescribed position by the bearings 262, together with the support bearings 267 and 268 incorporated in the motor 265. The drive shaft 230 is supported at a prescribed accuracy by the bearing 262 and bushing 266 until the assembly of the encoder is completed.

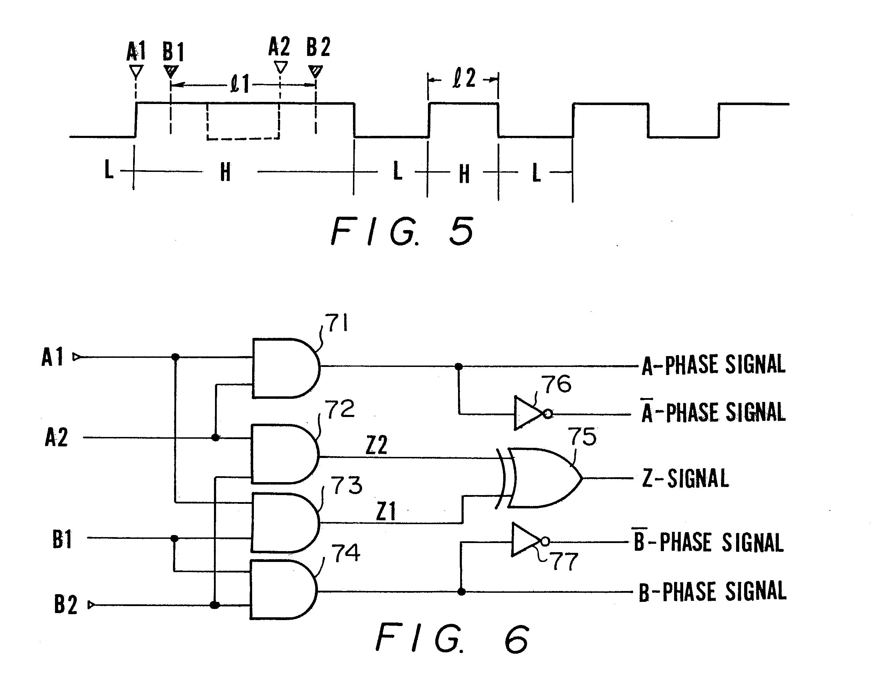

The magnetic head 210 comprises four sensors A1, A2, B1 and B2. The relationship between these sensors and the positional information written on the rotary shaft 220 is schematically illustrated in Figure 5. Specifically, the magnetic head 210 comprises two sets of sensors, namely A-phase signal sensors A1 and A2, and B-phase signal sensors B1 and B2. The A-phase signal sensors A1 and A2 are spaced apart from each other by a distance equivalent to a cycle width $\ell_1$ representing the positional information write cycle. The B-phase signal sensors B1 and B2 are similarly spaced apart from each other by a distance equivalent to $\ell_1$. Further, the two sets of sensors are spaced apart from each other by a distance equivalent to about one-half a recording width $\ell_2$ for a single item of positional information on the rotary disc 220. When this positional information is read by the sensors constituting the magnetic head 210, an output is obtained from the magnetic head that consists of "H" and "L" levels alternating at a fixed period, as shown in Figure 5.

Reference positional information (Z-position information) is written at one location on the outer peripheral surface 220a of the rotary disc 220. As shown in Figure 5, information is written between all of the ordinary items of positional information. One "L" level is made an "H" level and this serves as the reference positional information (Z-position information).

Figure 6 illustrates an output circuit on the control substrate 240 for producing position detection timing signals from read signals that are generated by the sensors constituting the magnetic head 210.

As shown in Figure 6, the output circuit includes AND gates 71 to 74, an EXCLUSIVE-OR gate 75, and two inverters, 76 and 77. The read outputs from the sensors A1, A2, B1 and B2 having the positional relationship shown in Figure 5 are fed to the output circuit of Figure 6. The outputs of sensors A1 and A2 enter the AND gate 71, which emits an A-phase signal. The outputs of sensors B1 and B2 enter the AND gate 74, which emtis a B-phase signal. These A-phase and B-phase signals are fed to the respective inverters 76 and 77, which output them as $\overline{A}$-phase and $\overline{B}$-phase signals, respectively. These signals are the same as the two-phase signals used by an ordinary encoder. With the above-described arrangement, each of the phase signals can be obtained exactly the same as before, even when the location at which the reference positional information (the Z-position information) is read.

The outputs of the sensors A1 and B1 are fed to the AND gate 73, which emits a Z1 signal. The outputs of the sensors A2 and B2 are fed to the AND gate 72, which emits a Z2 signal. The Z1 and Z2 signals are applied to the EXCLUSIVE-OR gate 75, the output of which is a Z signal. Thus, the Z signal is fed out only at the position of the reference positional information (the Z-position information).

More specifically, it will suffice to provide the outer peripheral surface of the rotary disc 220 with only a single recording line. In the case of the conventional rotary disc, which has the two A and B phases as one recording line, as well as a recording line for sensing the Z signal, the disc is required to have a thickness of 10 mm or more. By utilising only one recording line, as in the present embodiment, the disc thickness can be reduced to 4 mm. The main reason for this reduction is that the conventional disc requires that a significant space be provided between the two lines to separate them.

In accordance with this second embodiment of the invention, three signals, namely the A, B and Z signals, can be extracted by using only a single recording line. This makes it possible to provide a very small-sized, thin encoder.

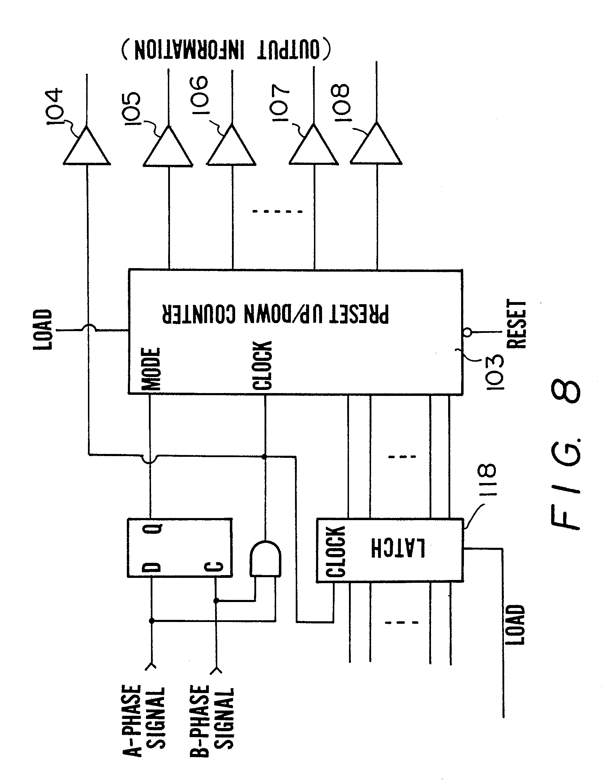

The direction of rotation can be sensed depending upon the detection timing of the A-phase and B-phase signals. If the order is detected to be the A-phase signal followed by the B-phase signal, then this will indicate forward-direction detection timing, by way of example, so that if the detected order is the B-phase signal followed by the A-phase signal, this will indicate reverse-direction detection timing. Accordingly, it will suffice if the preset counter 103 of Figure 3 is constituted by an up/down counter, in which case the counter would count up in the case of forward rotation and count down in the case of reverse rotation, depending upon the direction sensed by the above-described arrangement for sensing the rotating direction. Figure 8 illustrates the circuitry related to the preset counter in a case where the configuration just descirbed is adopted. In Figure 8, a mode input terminal MODE controls the up/down counting function of the counter 103. The counter 103 counts up when a "1" is applied to the mode input terminal, and down when a "0" is applied.

In accordance with the second embodiment, the shaft of the encoder is supported at only a single point by adopting a radial ballbearing support arrangement. This has the following advantages:

(A) As shown in Figure 7, some degree of freedom is obtained in terms of assembly. Though small, this is equivalent to the mounting tolerance ($\beta$) of the axis of bearing 162. This greatly facilitates the mounting operation. Moreover, movement in the axial direction

(A-A'-direction) can be suppressed.

(B) In comparison with double shaft support, only one bearing is required. This reduces cost.

(C) A coupling is unnecessary, so that there is no adverse influence from coupling play or the like. In addition, reliability is enhanced.

(D) The encoder can be reduced in size and thickness.

By constructing the magnetic head 210 to have two sets of readers a prescribed distance apart, the well-known two-phase signals can be sensed with a small number of magnetic tracks, thus enabling a further reduction in size. As a result, even if the encoder is equipped with a secondary battery of large size, the overall encoder can still be miniaturized.

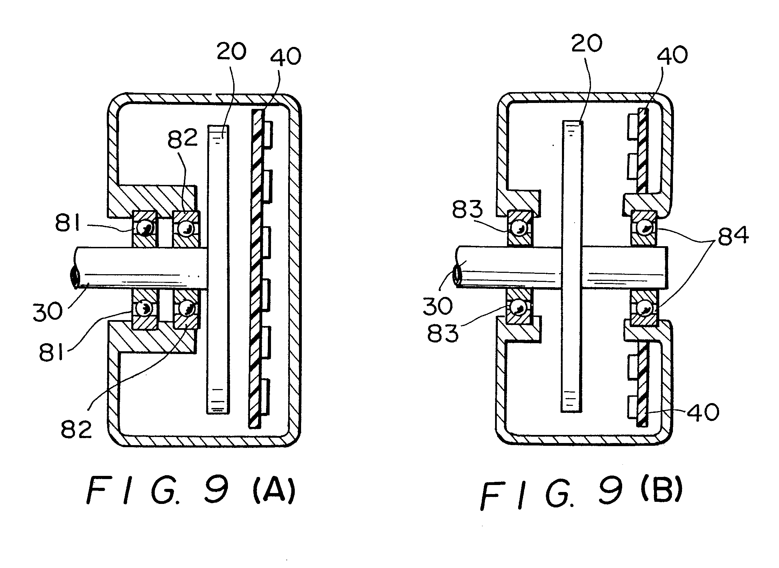

For comparison purposes, two known encoder constructions are shown in Figures 9A and 9B. In these Figures a disc 20 is supported on a drive shaft 30 adjacent a control base plate 40.

The construction shown in Figure 9A has two bearings, 81 and 82, to one side of the disc 20 whereas, in Figure 9B, the construction has two bearings, 83 and 84, one on each side of the disc 20.

**Claims**

1. An absolute measurement encoder coupled to a drive shaft (30,230) rotationally driven by driving means, and having means for detecting the actual amount of rotation of the drive shaft, characterised in that a rotary disc (20,220) is provided for storing positional information and rotated in accordance with rotation of the drive shaft; reading means (10,210) for reading out the positional information stored on said rotary disc as a serial signal sequence or sequences; and logic-linking means (101-121) feeding said signal sequence or sequences to counting output means for counting and holding information read by said reading means and feeding out the information in parallel mode.

2. An encoder as claimed in Claim 1, characterised in that means are provided for suppling operating power to said counting output means and said reading means at all times.

3. An encoder as claimed in Claim 2, characterised in that the power supply means includes a battery (15) chargeable by operating power supplied externally when said driving means operates.

4. An encoder as claimed in any preceding Claim, characterised in that means are provided for resetting the information held by said counting output means at any desired instant.

5. An encoder as claimed in any preceding Claim, characterised in that error correction means are provided to reset the count information held by said counting output each time said rotary shaft makes one revolution.

6. An encoder as claimed in any preceding Claim, characterised in that means are provided to feed out the rotational speed of the drive shaft.

7. An encoder as claimed in Claim 1, characterised in that the count information held by said counting output means (103) is counted up or down in accordance with the direction in which the drive shaft rotates.

8. An encoder as claimed in Claim 1, characterised in that said rotary disc stores positional information at a prescribed interval and is fixed to a motor drive shaft; said reading means include at least two sets of first and second readers (A1,A2; B1,B2) spaced apart from each other by a distance approximately the same as a cycle width representing a position information write cycle on said rotary disc, said two sets of readers being spaced apart from each other by a distance approximately one-half said interval at which the positional information is written on said rotary disc.

9. An encoder as claimed in Claim 8, characterised in that said two sets of readers of said reading means output two phase signals displaced from each other by a predetermined phase, read signals of said phases are rendered effective by the logical product of read positional information from the first and seocnd readers of each set, and when a recorded portion for predetermined position detection is read, an EXCLUSIVE-OR gate (75) forms an output between a logical product output of each of the first readers in the two sets and a logical product output of each of the second readers in the two sets to be used as a predetermined position detection signal.

10. An encoder as claimed in Claim 8 or Claim 9, characterised in that the two sets of readers of said reading means are arranged at an interval which is approximately one-fourth the cycle width representing the position information write cycle on said rotary disc.

11. An encoder as claimed in any one of Claims 8 to 10, characterised in that the direction of rotation of said rotary disc is sensed for the timing of the read signal sequences from the two sets of said readers.

12. An encoder as claimed in any preceding Claim, characterised in that it is secured to a motor and fixed to a drive shaft of the motor for detecting the degree of rotation of the drive shaft, the drive shaft of the motor being fitted and retained in a disc drive shaft having a hollow portion; and supporting means (52,53; 252) are disposed adjacent a fixed side of the motor for supporting said disc drive shaft in such a manner that said disc drive shaft is freely rotatable, and is fixed against movement in the axial direction.

13. An encoder as claimed in any preceding Claim, characterised in that the supporting means has a single bearing (262) and includes freely detachable provisional retaining means (261) for retaining said disc drive shaft at an end thereof opposite an end supported by said supporting means, said provisional means being detached after assembly of said encoder on said motor.

0267040

F I G. 1

F I G. 2

0267040

READING HEAD PORTION 10b

READING HEAD PORTION 10a

102

101

130

115  116

117

103

CLOCK

LOAD

LATCH

PRESET COUNTER

LOAD

RESET

118

104
105
106
107
108

(OUTPUT POSITION INFORMATION)

POWER SUPPLY  15

RPM COUNTER 119

LATCH 120

TIMEKEEPING MEANS 121

109
110
111

(RPM INFORMATION)

F I G. 3

FIG. 4

FIG. 7

FIG. 5

FIG. 6

F I G. 8

F I G. 9 (A)

F I G. 9 (B)